# EUROPÄISCHE PATENTSCHRIFT

(11) **EP 0 387 407 B1**
(45) Veröffentlichungstag und Bekanntmachung des Hinweises auf die Patenterteilung: **08.09.1993**
(21) Anmeldenummer: 89121637.6
(22) Anmeldetag: 23.11.1989
(51) Int. Cl.: G02B 5/18, H01L 21/306

(54) **Beugungsgitter**
Diffraction grating
Réseau de diffraction

(30) Priorität: 23.02.1989 CH 650/89
(43) Veröffentlichungstag der Anmeldung: 19.09.1990
(73) Patentinhaber: Landis & Gyr Business Support AG, 6301 Zug (CH)
(72) Erfinder: Dschen Tsing, CH-8953 Dietikon (CH)
(74) Vertreter: Müller, Hans-Jürgen, Dipl.-Ing.

(56) Entgegenhaltungen:
- EP-A- 0 059 304
- EP-A- 0 198 199
- EXTENDED ABSTRACTS, Band 87-2, 1987, Seite 769, Zusammenfassung Nr. 547, Electrochemical Society, Princeton, NJ, US; E. BASSOUS: "Anisotropic etching of silicon for 3-D microstructure fabrication - A review"
- IBM TECHNICAL DISCLOSURE BULLETIN, Band 24, Nr. 2, Juli 1981, Seite 1084, New York, US; A.N. BROERS et al.: "Method for high-speed fabrication of ultra-fine structures"
- MICROELECTRONIC ENGINEERING, Band 2, Nr. 1/3, Oktober 1984, Seiten 82-93, Amsterdam, NL; D.C. FLANDERS: "Nanometer structure and device fabrication"

## Beschreibung

Die Erfindung bezieht sich auf ein Beugungsgitter der im Oberbegriff des Anspruchs 1 genannten Art.

Solche Beugungsgitter eignen sich als Beugungselement in Spektrographen oder als kostengünstige Vorlagen zum Anfertigen galvanotechnisch erzeugter Kopien, die beispielsweise vorteilhaft als Matrizen zum Prägen von Kopien in einen Kunststoff verwendet werden.

In Journal of Applied Physics, Vol. 46, No. 5, May 1975, Seiten 2163 bis 2166 beschreiben Won-Tien Tsang und Shyh Wang die Herstellung von Beugungsgittern auf dünnen Scheiben ("Wafern") aus einkristallinem Silizium. Wie in der IC-Technologie üblich, wird die Oberfläche der Wafer durch die {100}-Ebene gebildet. Zunächst wird auf der Oberfläche auf bekannte Art eine Aetzmaske aus SiO₂ erzeugt. Anschliessend wird durch diese Aetzmaske hindurch das freiliegende Silizium chemisch abgetragen, wobei ein Siliziumkristall vorzugsweise in der 〈100〉-Richtung aufgelöst wird, d. h. senkrecht zur {100}-Ebene, während die Wirkung des Aetzmittels in der 〈111〉-Richtung wenigstens 30mal geringer ist. Das entstehende symmetrische Reliefprofil weist V-förmige Nuten auf, deren Flanken von {111}-Ebenen gebildet werden, und ist bis auf die Gitterfrequenz durch den Kristallbau vorbestimmt. Derart erzeugte Beugungsgitter sind daher von hoher Qualität, allerdings ist die Aetzzeit wegen des Unterätzens der Maske und wegen der daraus resultierenden Gitterfehler kritisch.

In EP-59 304 wird die Herstellung von asymmetrischen Gittern auf einem Wafer mit der {hhl}-Ebene beschrieben, wobei die Aetz-und Maskentechnik auf der vorgängig zitierten Arbeit von Tsang et al. basiert. In EP-59 304 werden die Gefahren des Unterätzens der Aetzmaske auch erwähnt.

Derartige anisotrope Aetzverfahren zur Herstellung V-förmiger Nuten sind beispielsweise auch für GaAs (aus den obigen Zitaten) und InP (Technische Rundschau Heft 52, 1988, Seite 19) bekannt.

K. E. Petersen begrenzt die Aetztiefen in Gräben in einem Wafer aus Silizium mittels einer in einer vorbestimmten Tiefe angeordneten, stark p-dotierten Schicht (IBM Journal of Research and Development, Vol. 23, No. 4, July 1979, Seiten 376 bis 385), da das stark p-dotierte Material dieser Schicht von bestimmten, anisotrop wirkenden alkalischen Aetzmitteln weniger stark angegriffen wird als reines Silizium in der 〈111〉-Richtung.

Weiter ist bekannt, dass stark p-dotiertes Silizium mittels eines bekannten saueren, isotrop wirkenden Aetzmittels, einer Mischung von Fluss-, Salpeter- und Essigsäure, leicht aufgelöst wird im Gegensatz zum schwerlöslichen undotierten Silizium.

W. K. Chan et al. (Applied Optics Vol. 27, No. 8, 1988, Seiten 1377 bis 1380) erzeugen mit der gleichen Maske Positivformen bzw. Negativformen aus geätztem Silizium, beispielsweise für Beugungsgitter, wobei in einer Photoresistschicht durch ein spezielles Entwicklungsverfahren in vorbestimmten Teilflächen ein positives bzw. ein negatives Abbild der Maske erzeugt wird.

In Applied Physics Letters, Vol. 43, Heft 9 vom 1. November 1983, Seiten 874 bis 875 beschreiben Erik H. Anderson et al. die Erzeugung feiner gitterförmiger Reliefstrukturen in einer Photoresistschicht mittels holographischer Lithographie. Die nach dem Entwickeln erhaltenen Reliefstrukturen sind typisch nur 0,1 µm tief. Eine dünne, aus seitlicher Richtung aufgedampfte Metallschicht deckt nur die Erhebungen in der Photoresistschicht ab, wobei die dazwischenliegenden breiten Talsohlen gänzlich frei von Metall bleiben. Der unbedeckte Photoresist wird mittels Sauerstoffionen beim anschliessenden reaktiven Ionenätzen wegoxidiert, während die Metallschicht auf den Erhebungen den darunterliegenden Photoresist vor dem Abtrag schützt. Das Ionenätzen vertieft die Höhenunterschiede der Reliefstruktur auf über 0,5 µm. Gitterstrukturen aus Photoresist mit rund 5000 Linien pro mm sind mit dieser Methode erreichbar.

R. H. M. Dumas et al. berechnen Profile dieser Reliefstrukturen in Abhängigkeit der Belichtungsbedingungen mit Interferenzmustern (IEE Proc. Vol. 132, Pt.J, No. 6, December 1985, Seiten 331 bis 335).

Der Erfindung liegt die Aufgabe zugrunde, ein kostengünstiges Beugungsgitter hoher optischer Qualität zu schaffen und ein preiswertes und einfaches Verfahren zu dessen Herstellung anzugeben.

Die genannte Aufgabe wird erfindungsgemäss durch die Merkmale der Ansprüche 1 und 7 gelöst.

Nachfolgend werden Ausführungsbeispiele der Erfindung anhand der Zeichnungen näher erläutert.

Es zeigt:
- Fig. 1: einen Ausschnitt aus einem Wafer mit einem geätzten Beugungsgitter,
- Fig. 2: eine schematische Darstellung eines Verfahrens in vier Schritten a) bis d) zur Herstellung einer Implantiermaske,
- Fig. 3: eine schematische Darstellung eines anderen Verfahrens in drei Schritten a) bis c) zur Implantiermaskenherstellung und
- Fig. 4: einen Ausschnitt aus dem ungeätzten Wafer mit einer Deckschicht.

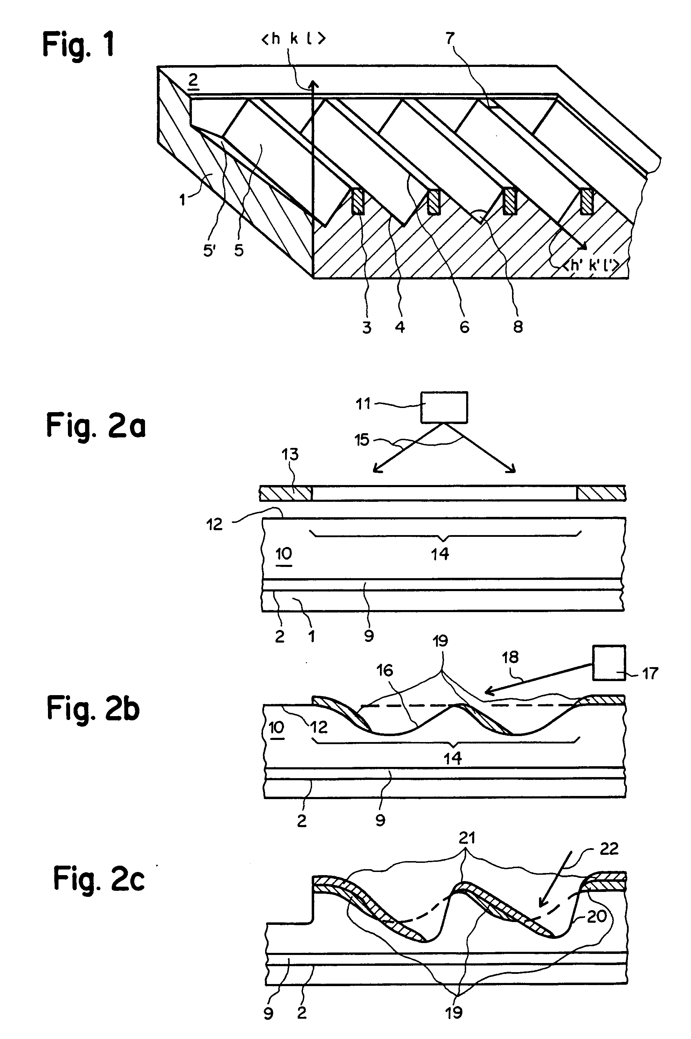

In der Fig. 1 bedeutet 1 einen Wafer aus einem Einkristall, 2 eine Oberfläche des Wafers 1, 3 eine dotierte Zone, 4 ein Reliefprofil, 5 bzw. 5′ je eine Profilfläche, 6 einen Grat des Reliefprofils 4, 7 eine Plateaubreite der Zone 3 bzw. des Grates 6, 8 einen Profilwinkel zwischen den Profilflächen 5 und 5′ und 〈hkl〉 eine zur Oberfläche 2 senkrechte Richtung des Einkristalls. In der Zeichnung sind die beiden Schnittflächen des Wafers 1 schraffiert und zur Oberfläche 2 vertikal. Der Uebersicht wegen sind die Bezugszahlen 3 bis 8 nur einmal angegeben.

Von einem gezüchteten Einkristall eines Halbleitermaterials, der eine geringe Eigenleitung bei einer vorbestimmten Aetztemperatur aufweist, werden scheibenförmige, dünne Wafer 1 derart abgeschnitten, dass wenigstens eine der beiden scheibenförmigen, polierten Oberflächen 2 parallel zu einer vorbestimmten {hkl}-Ebene des Einkristalls ist, wobei in den Klammern die in der Kristallographie üblichen drei Miller'schen Indices hkl stehen. Die auszeichnende 〈hkl〉-Richtung legt die Orientierung des Wafers 1 in Bezug auf dessen Kristallbau fest.

Die dem Fachmann bekannten, anisotrop wirkenden alkalischen Aetzmittel tragen undotiertes Halbleitermaterial am schnellsten in der <100>-Richtung und am langsamsten in der 〈111〉-Richtung ab. Die freigeätzten Profilflächen 5, 5′ sind daher {111}-Ebenen.

Das Halbleitermaterial ist stark dotiert, wenn die Dichte der vorbestimmten, zum Dotieren in das Halbleitermaterial eingebrachten Fremdatome einen Wert von 10¹⁸cm⁻³ überschreitet. In einem derart stark p-dotiertem Material erfolgt der Angriff dieser Aetzmittel noch langsamer.

Die {111}-Ebenen und die stark p-dotierten Zonen 3 werden daher vorteilhaft zusammen als Begrenzungen des Aetzvorganges in diesen Halbleitermaterialien eingesetzt.

Das Beugungsgitter mit dem Reliefprofil 4 wird mit Hilfe einer Aetzmaske in die Oberfläche 2 eingeätzt. Die Aetzmaske setzt sich wenigstens aus beispielsweise parallelen Zonen 3 zusammen, die z. B. die Form schmaler Rechtecke besitzen.

Beide Längsseiten der Zonen 3 sind auf eine in der Oberfläche 2 liegende vorbestimmte 〈h′k′l′〉-Richtung des Einkristalls mit einer Toleranz von ±1° ausgerichtet. Die Länge dieser Längsseiten ist beispielsweise durch die Abmessungen des Beugungsgitters begrenzt.

Die auszeichnende 〈hkl〉-Richtung des Wafers 1 und die vorbestimmt ausgerichtete 〈h′k′l′〉-Richtung bestimmen wesentlich die Form des Reliefprofils 4. Im allgemeinen ergibt sich ein sägezahnförmiges asymmetrisches Reliefprofil 4 mit verschieden steilen Profilflächen 5, 5′, wobei die benachbarten Profilflächen 5 und 5′ untereinander immer einen Profilwinkel 8 von 70,52° bilden. Die Schnittlinien der Profilflächen 5 und 5′ bestimmen die 〈h′k′l′〉-Richtung, auf die die Zonen 3 vorteilhaft ausgerichtet sind.

Weist beispielsweise die auszeichnende 〈hkl〉-Richtung des Wafers 1 die Miller'schen Indices 〈100〉 auf, wird beim anisotropen Aetzen ein symmetrisches Beugungsgitter erhalten, wobei die 〈h′k′l′〉-Richtung die 〈110〉-Richtung ist.

In einer anderen Ausführung weist der Wafer 1 die auszeichnende 〈110〉-Richtung auf. Hier stehen die {111}-Ebenen senkrecht zur Oberfläche 2. Das zwischen benachbarten Zonen 3 liegende Halbleitermaterial wird beim Aetzen entfernt. Die zu der Oberfläche 2 vertikalen Profilflächen 5 werden von den {111}-Ebenen und die zu der Oberfläche 2 parallelen Profilflächen 5′ von den {110}-Ebenen gebildet. Die 〈h′k′l′〉-Richtung der Schnittlinien zwischen den Profilflächen 5 und 5′ weisen in die 〈112〉-Richtung. Das Beugungsgitter auf einem derartigen Wafer 1 erhält beim Aetzen ein rechteckförmiges Reliefprofil 4, dessen Tiefe mit der Einwirkzeit kontrollierbar ist.

In einer Variante der Erzeugung von Rechteckgittern wird die ganze Oberfläche 2 eines Wafers 1 mit der auszeichnenden 〈110〉-Richtung vorteilhaft zuerst stark p-dotiert. Eine anschliessend aufgewachsene epitaktische Schicht aus undotiertem Halbleitermaterial ist die Trägerin der Aetzmaske. Beim Aetzen begrenzt die p-dotierte, alte Oberfläche 2 die Wirkung des Aetzmittels und damit die Tiefe des Reliefprofils 4. Die epitaktische Schicht weist beispielsweise eine Dicke im Bereich von 0,1 µm bis 0,5 µm auf entsprechend der vorbestimmten Tiefe des Reliefprofils 4.

Die aus den stark p-dotierten Zonen 3 bestehende Aetzmaske ist Teil des Halbleitermaterials unmittelbar unter der Oberfläche 2 und weist keine Materialgrenze zum nicht dotierten Material des Wafers 1 auf. Gegenüber den bisherigen Maskentechniken bietet diese dotierte Aetzmaske den Vorteil, dass sie wegen des Fehlens der Materialgrenze praktisch nicht unterätzt und abgehoben wird, auch wenn die Aetzzeit oder die Aetztemperatur überschritten werden.

Zum Dotieren eignet sich beispielsweise das bekannte Ionenimplantierverfahren. Die Ionen werden mit geringer Energie von beispielsweise 30 keV in die Oberfläche 2 hineingeschossen und dringen bei geringer seitlicher Streuung höchstens etwa 100 nm in den Wafer 1 ein. Bis in diese Tiefe wird der Halbleiter dotiert. Die Erzeugung der Aetzmaske erfolgt mittels einer Implantiermaske, die das Dotieren auf die Zonen 3 begrenzt.

Nach dem Aetzen bilden die Zonen 3 die Grate 6 des Reliefprofils 4. Die Plateaubreite 7 der Zonen 3 bzw. der Grate 6 bestimmt zusätzlich die Form des Reliefprofils 4 und eine höchst mögliche Gitterfrequenz. Beispielsweise weisen sägezahnförmige Beugungsgitter scharfkantige Grate 6 auf. Im Vergleich zum Abstand benachbarter Grate 6 ist die Plateaubreite 7 klein, beispielsweise ein Zehntel des Abstandes benachbarter Grate 6. Für Beugungsgitter, die im visuellen Bereich des Lichtes verwendet werden, beträgt die Plateaubreite 7 vorteilhaft weniger als 0,1 µm. Derartig feine Strukturen in der Implantiermaske für scharfkantige Beugungsgitter können auf bekanntem lichtoptischen Wege nicht mehr erzeugt werden. Dazu sind z. B. die bekannten Verfahren der Lithographie mit Röntgen-und Elektronenstrahlen notwendig.

Die nachstehend beschriebenen Verfahren zur Erzeugung der Aetzmaske umgehen die Herstellung der Implantiermaske auf teueren Anlagen, die für die Lithographie mit Röntgen-oder Elektronenstrahlen benötigt werden, und sind vorteilhaft auf den in der IC-Technik üblichen Einrichtungen durchführbar.

Die Herstellung der Beugungsgitter beginnt mit der Auswahl der Wafer 1. Besonders preiswert sind Wafer 1 aus Silizium, da dieses Halbleitermaterial von hoher Reinheit und mit einer vorbestimmten 〈hkl〉-Richtung leicht und kostengünstig erhältlich ist. Auf dem Wafer 1 wird in einem ersten Verfahrensschritt eine Implantiermaske erzeugt, die für die Herstellung der Aetzmaske in einem zweiten Verfahrensschritt benötigt wird. Die Herstellung endet mit dem Aetzen und dem Zuschneiden des Beugungsgitters.

Die Oberfläche 2 (Figur 2a) des Wafers 1 wird mit einer bekannten, auf einer Interferenzwirkung basierenden Antireflexschicht 9 überzogen. Sie verhindert Reflexionen von Licht an der Oberfläche 2 und dient als Unterlage für eine Photoresistschicht 10. Als Photoresist eignet sich beispielsweise der Typ AZ 5214 mit einer Auftragsdicke im Bereich von 300 nm bis 700 nm.

Denkbar für dieses Verfahren ist auch die Verwendung eines Photoresists, welcher ein im wirksamen Wellenlängenbereich des Lichtes absorbierender Farbstoff enthält, der die Intensität von reflektiertem Licht dämpft.

Die Photoresistschicht 10 wird auf der einer Lichtquelle 11 zugewandten Fläche 12 auf einer mittels einer Blende oder einer Maske 13 begrenzten Gitterfläche 14 belichtet, beispielsweise mit einem Interferenzmuster oder mit einem Streifenmuster, das die vorbestimmte Gitterfrequenz aufweist.

In einem ersten Verfahren erzeugt die Lichtquelle 11 kohärentes Licht, das mit nicht gezeigten Mitteln das Interferenzmuster bildet, wobei die Richtung von hellen Streifen des Interferenzmusters sorgfältig auf die vorbestimmte 〈h′k′l′〉-Richtung (Figur 1) ausgerichtet wird.

Als kohärente Lichtquelle 11 (Figur 2a) eignet sich beispielsweise ein HeCd-Laser mit einer Wellenlänge von 325 nm und einer Leistung von etwa 10 mW. Licht 15 weist eine genügende Intensität auf, um Gitterflächen 14 von etwa 3 cm² Fläche zu belichten. In den hellen Streifen des Interferenzmusters wird der Photoresist nur etwa 100 nm tief in die Photoresistschicht 10 hinein für eine Entwicklung ausreichend belichtet.

In einem zweiten Verfahren wird die Maske 13 mit einem feinen, vorbestimmt ausgerichteten Streifenmuster auf die Fläche 12 aufgelegt und wird mittels kurzwelligem, inkohärentem Licht 15 aus der Lichtquelle 11 auf den Photoresist kopiert, der nur etwa 100 nm tief in die Photoresistschicht 10 hinein für die Entwicklung genügend durchbelichtet wird.

Nach dem Entwickeln der Photoresistschicht 10 (Figur 2b) weist die Gitterfläche 14 ein wellenartiges Profil 16 mit Höhenunterschieden von etwa 100 nm und mit der vorbestimmten Gitterfrequenz auf. Das Profil 16 wird durch den geringen Kontrast der optischen Belichtung vorbestimmt. Diese Belichtungsart weist den Vorteil auf, dass die Mittel dazu kostengünstig sind.

Die Photoresistschicht 10 mit dem Profil 16 wird zunächst aus einer Metalldampfquelle 17 unter einer ersten Seitenrichtung 18 mit einem Metall, vorteilhaft Au oder Cr, derart bedampft, dass das Profil 16 nur auf der Metalldampfquelle 17 zugewandten Flanken mit einer etwa 30 nm bis 50 nm dicken ersten Metallschicht 19 bedeckt wird. Die anderen, von der Metalldampfquelle 17 abgewandten gegenüberliegenden Flanken bleiben unbedeckt. Ein erster Einfallswinkel zwischen der auszeichnenden 〈hkl〉-Richtung (Figur 1) und der ersten Seitenrichtung 18 (Figur 2b) ist vorbestimmt und liegt z. B. im Bereich von 30° bis 80°. Die Flächen 12 ausserhalb der Gitterfläche 14 werden vorteilhaft durch einen hier nicht gezeigten Schirm geschützt, damit sie nicht mit der ersten Metallschicht 19 abgedeckt werden.

Während des reaktiven Ionenätzens wird der nicht mit der Metallschicht 19 abgedeckte Photoresist, d. h. auf den unbedeckten Flanken und auf den unbedeckten Flächen 12, mittels Sauerstoffionen (Oxidation) kontrolliert abgetragen. Die von der Metalldampfquelle 17 abgewandten Flanken werden durch den Abtrag steiler und U-förmig bis in eine vorbestimmte Tiefe abgetragen, wobei jedoch die Photoresistschicht 10 nicht bis auf die Antireflexionsschicht 9 bzw. auf die Oberfläche 2 wegoxidiert wird. Aus dem Profil 16 entsteht eine asymmetrische, neue Profilstruktur 20 (Figur 2c).

Die Profilstruktur 20 wird mit einer zweiten Metallschicht 21 überdeckt, wobei die in der Figur 2c nicht dargestellte Metalldampfquelle 17 (Figur 2b) jetzt unter einer zweiten Seitenrichtung 22 angeordnet ist. Ein zweiter Einfallswinkel weist, wiederum gemessen zwischen der auszeichnenden 〈hkl〉-Richtung (Figur 1) und der zweiten Seitenrichtung 22 (Figuren 2b und 2c), einen Wert von weniger als 30° auf und ist so gewählt, dass jede von der Metalldampfquelle 17 abgewandte Flanke und ein unmittelbar daran anschliessender schmaler Streifen vorbestimmter Breite in jedem Minimum der Profilstruktur 20 nicht von der zweiten Metallschicht 21 bedeckt wird. Die ausserhalb der Gitterfläche 14 liegende Flächen 12, die nicht mit der ersten Metallschicht 19 bedeckt sind und durch den oben erwähnten Schirm geschützt sind, erhalten ebenfalls keine zweite Metallschicht 21.

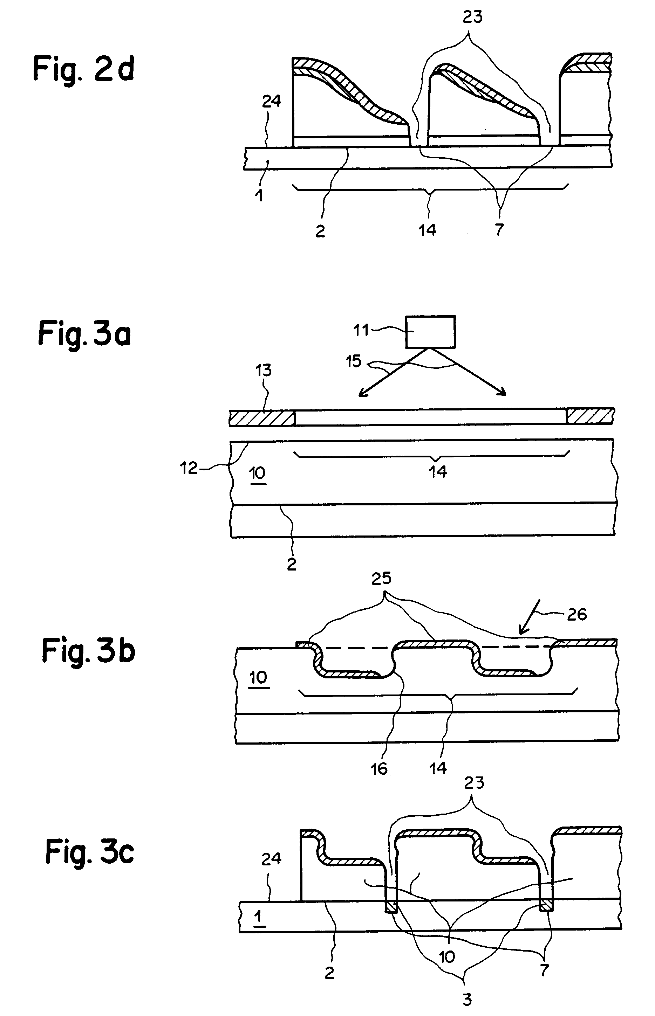

Das zweite reaktive Ionenätzen trägt anschliessend mittels einer Mischung von Sauerstoff- und Fluorionen den freiliegenden, nicht von den Metallschichten 19 und 21 geschützten Photoresist und die Antireflexschicht 9 bis auf die Oberfläche 2 ab, wobei die Oberfläche 2 in Oeffnungen 23 (Figur 2d) und in ausserhalb der Gitterfläche 14 gelegenen Gebieten 24 zum Dotieren freigelegt wird.

Damit ist auf dem Wafer 1 eine Implantiermaske erzeugt worden. Die Oeffnungen 23 weisen einen rechteckförmigen Querschnitt mit der Plateaubreite 7 und einer durch die Maske 13 (Figur 2a) bestimmten Länge auf. Andere Querschnitte für die Oeffnungen 23 (Figur 2d) sind denkbar.

Ein anderes Belichtungsverfahren, das von E. H. Anderson et al. erwähnt wird, erzeugt auf der Gitterfläche 14 in der Photoresistschicht 10 ein Profil 16 mit leicht überhängenden Flanken (Figur 3a). Kohärentes Licht 15 aus der Lichtquelle 11, das auf der Fläche 12 das streifenförmigen Interferenzmuster erzeugt, wird mittels der Maske 13 auf die Gitterfläche 14 begrenzt und spiegelt sich an der Oberfläche 2. Senkrecht über der Oberfläche 2 entstehen daher stehende Wellen. Die Belichtung mit einer Ueberlagerung des streifenförmigen Interferenzmusters mit den stehenden Wellen erzeugt das nach Dumas et al. vorbestimmte Profil 16.

Die entwickelte Photoresistschicht 10 (Figur 3b) weist in der Gitterfläche 14 ein Profil 16 mit einer Höhendifferenz von etwa 100 nm. Die Form des Profils 16 mit den leicht überhängenden Flanken weist den Vorteil auf, dass nur eine einzige Metallschicht 25 aus einer einzigen Seitenrichtung 26 aufgedampft werden muss und dass nur ein einmaliges reaktives Ionenätzen mittels Sauerstoffionen für die Erzeugung der Implantiermaske benötigt wird.

Die Dicke der einzigen Metallschicht 25 beträgt etwa 30 nm bis 50 nm. Ein einziger Einfallswinkel, wiederum gemessen zwischen der auszeichnenden 〈hkl〉-Richtung (Figur 1) und der einzigen Seitenrichtung 26 (Figur 3b), beträgt weniger als 45°. Beim Bedampfen unter diesem steilen Einfallswinkel werden die leicht überhängenden, abgewandten Flanken des Profils 16 und die unmittelbar an diesen Flanken anschliessenden, schmalen Streifen nicht mit der Metallschicht 25 abgedeckt.

Während des reaktiven Ionenätzens wird die von der Metallschicht 25 unbedeckte Photoresistschicht 10 mittels Sauerstoffionen in den Oeffnungen 23 (Figur 3c) und in den Gebieten 24 abgetragen und die Oberfläche 2 zum Dotieren freigelegt.

Die beschriebenen Verfahren zur Erzeugung der Implantiermaske weisen wesentliche Vorteile auf, da die Plateaubreite 7 (Figuren 2d und 3c) im wesentlichen nur von der Wahl der Grösse des zur Bedampfung notwendigen, steilen zweiten bzw. einzigen Einfallswinkels bestimmt wird. Die übrigen Verfahrensparameter, wie z. B. die Dicke der Photoresistschicht 10, die Belichtungsart mit dem Streifenmuster, der Belichtungskontrast im Streifenmuster sowie die Parameter für das Ionenätzen, beeinflussen hingegen die Plateaubreite 7 nur gering.

Die nach diesen Verfahren hergestellten Implantiermasken weisen in den Oeffnungen 23 Plateaubreiten 7 von beispielsweise 40 nm auf.

Die maskierten Wafer 1 werden in freigelegten Teilflächen der Oberfläche 2 mit Ionen der III. Hauptgruppe dotiert, wobei die Dosis 10¹⁵cm⁻² oder mehr beträgt. Bei einer Eindringtiefe dieser Ionen von etwa 100 nm weist der Halbleiter somit eine Dichte dieser Fremdatome von wenigstens 10²⁰cm⁻³ auf und das Halbleitermaterial ist daher stark p-dotiert. Die minimale Dicke der verbleibenden Photoresistschicht 10 wird durch die Energie dieser Ionen vorbestimmt. Beispielsweise werden für das Silizium vorteilhaft Borionen von 30 keV zu diesem Zweck verwendet.

Die nicht maskierte Rückseite des Wafers 1 (Figur 3c) wird anschliessend mit den gleichen Parametern dotiert, um eine ätzfeste Rückseite zu erhalten. Der Vorteil dieser Massnahme ist die Schonung der Aktivität der Aetzlösung, da sie nur an den vorgesehenen Stellen zwischen benachbarten Zonen 3 undotiertes Silizium angreift und auflöst.

Vor dem Aetzen wird die Implantiermaske mittels eines bekannten Standardverfahrens entfernt.

Die stark p-dotierten Teilflächen der Oberfläche 2 in den Zonen 3 und in den Gebieten 24 bilden die in die Oberfläche 2 eingebaute Aetzmaske.

Als eine bekannte, anisotrop wirkende alkalische Aetzlösung für Silizium wird beispielsweise EDP (ein Aethylendiamin-Brenzchatechin-Wasser System) verwendet. Die Aetzgeschwindigkeit beträgt vorteilhaft etwa 500 nm pro Minute in der 〈100〉-Richtung. Bei einer optimalen Badtemperatur von 60°C bis 70°C benötigt der Aetzvorgang zwischen 20 Sekunden und maximal einigen Minuten.

Der Aetzvorgang ist selbstbegrenzend, wenn sich schneidende 〈111〉-Ebenen die Profilflächen 5 und 5′ bilden. Die nach diesen Verfahren erzeugte Aetzmaske reduziert vorteilhaft die beim Stand der Technik gefürchteten Unterätzungen, da, wie bereits erwähnt, keine Materialgrenzen zwischen der Aetzmaske und dem undotierten Silizium vorhanden sind. Die Beugungsgitter weisen daher eine hohe Genauigkeit auf und sind reproduzierbar herstellbar. Die Unterätzungen treten erst nach einem Ueberschreiten der Einwirkungszeit um mehr als das drei- bis zehnfache auf, so dass auch dieser Parameter nicht kritisch ist.

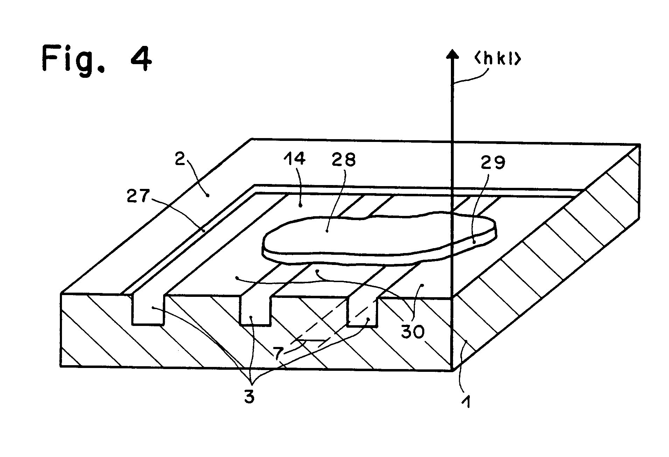

Eine Erweiterung des beschriebenen Aetzverfahrens erzeugt nebeneinander, z. B. in der gleichen Gitterfläche 14 (Figur 4), spiegelsymmetrische Beugungsgitter und weist vorteilhaft weniger Herstellschritte auf als die von W. K. Chan et al. erwähnte Methode.

Der Wafer 1 besitzt beispielsweise die auszeichnende 〈110〉-Richtung und wenigstens in einer Gitterfläche 14, die in der Zeichnung nur aus darstellerischen Gründen mit einer Markierung 27 umrahmt ist, eine Aetzmaske mit den p-dotierten Zonen 3. Die Gitterfläche 14 ist in wenigstens einem Teilgebiet 28 mit einer Deckschicht 29 überdeckt. Beispielsweise eignet sich für die Deckschicht 29 Aluminium mit einer Dicke von etwa 100 nm, wenn EDP als Aetzmittel verwendet wird. Das Aetzen der derart vorbereiteten Wafer 1 erfolgt in zwei Schritten.

In einem ersten Schritt wird, wie oben ausgeführt, mit dem anisotrop wirkenden alkalischen Aetzmittel das Beugungsgitter mit einem rechteckförmigen Gitterprofil ausserhalb der Teilgebiete 28 in die Gitterfläche 14 geätzt. In Inseln 30 zwischen den Zonen 3 wird das undotierte Silizium beispielsweise bis wenigstens auf die doppelte Eindringtiefe der Ionen beim Dotieren der Zonen 3 abgetragen.

Im zweiten Schritt wirkt das bekannte sauere, isotrop wirkende Aetzmittel auf die Oberfläche 2 ein, nachdem Deckschichten 29 aus Aluminium mit einem Standardverfahren entfernt wurden. Das sauere Aetzmittel löst selektiv alles p-dotierte Silizium aus der Oberfläche 2. Zurück bleiben in den Teilgebieten 28 U-förmige Nuten, deren Räume vor dem Aetzen von p-dotiertem Silizium eingenommen wurden. Sie weisen eine Tiefe auf, die der Eindringtiefe der Ionen beim Dotieren entspricht. Ausserhalb der der Teilgebiete 28 werden die Grate 6 (Figur 1) abgetragen, wobei ein Beugungsgitter mit einem rechteckförmigen Gitterprofil entsteht, dessen Tiefe wenigstens die einfache Eindringtiefe der Ionen beim Dotieren aufweist. Auch dieser Aetzschritt wird durch das undotierte Silizium selbst begrenzt. In der Gitterfläche 14 (Figur 4) ist das Beugungsgitter in den Teilgebieten 28 daher spiegelsymmetrisch zum rechteckförmigen Beugungsgitter ausserhalb der Teilgebiete 28.

Da die Tiefe der p-dotierten Zonen 3 von der Eindringtiefe der Ionen abhängt, lassen sich mit Vorteil mit einem zweimaligen Dotieren bei zwei verschiedenen vorbestimmten Energien die Tiefen des Gitterprofils für diese spiegelsymmetrische Beugungsgitter in einem weiten Bereich vorbestimmen, wobei die Dicke der Implantiermaske auf die höchste vorbestimmte Energie ausgelegt ist. Nach einem ersten Dotieren bei niedriger Energie werden die Oeffnungen 23 der Implantiermaske ausserhalb der Teilgebiete 28 mit einer Schutzschicht aus Photoresist abgedeckt. Die etwa 0,5 µm bis 2 µm dicke Schutzschicht schirmt die Zonen 3 bei einem zweiten Dotieren bei höherer Energie ab. Nur die Zonen 3 in den Teilgebieten 28 werden daher tiefer dotiert. Der Bereich der praktisch verwendbaren Ionenenergie liegt zwischen 25 keV bis 100 keV.

Der Abstand benachbarter Zonen 3 bestimmt lokal eine Gitterfrequenz, wobei im einfachsten Fall alle Zonen 3 im gleichen Abstand angeordnet sind. Es ist auch denkbar, dass sich die Gitterfrequenz innerhalb der Gitterfläche 14 nach einer vorbestimmten Funktion ändert. Für asymmetrische Beugungsgitter praktisch verwendbare Gitterfrequenzen liegen zwischen 10 und 5000 Gitterlinien pro mm, jedoch sind bei symmetrischen Beugungsgittern auch mehr als 5'000 Gitterlinien pro mm erreichbar.

Die handelsübliche Grösse eines Wafers 1 ermöglicht die Herstellung mehrerer Beugungsgitter gleichzeitig in einem einzigen Aetzvorgang. Die Beugungsgitter auf einem Wafer sind identisch oder unterscheiden sich beispielsweise in der Gitterfläche 14 des Beugungsgitters, in der Gitterfrequenz, in der Plateaubreite 7 oder in der lokalen Aenderung der Gitterfrequenz innerhalb der Markierung 27.

Die auf einen Wafer 1 geätzten Beugungsgitter lassen sich mit den in der IC-Technologie bekannten Mitteln vorteilhaft auf ein vorgegebenes Mass verkleinern oder teilen.

Andere Halbleiter, die eine geringe Eigenleitung bei der Aetzbadtemperatur aufweisen, wie z. B. Ge, GaAs, InP usw., eignen sich auch für die Herstellung von Beugungsgittern. Die für den Halbleiter geeigneten Dotierelemente und Aetzmittel sind dem Fachmann bekannt.

## Patentansprüche

1. Beugungsgitter, eingeätzt in einen Wafer (1) aus einem Einkristall eines Halbleiters, mit einem durch eine auszeichnende 〈hkl〉-Richtung des Wafers vorbestimmten Reliefprofil (4) und mit einer Gitterfrequenz von mehr als 10 pro mm, dadurch gekennzeichnet, dass das Reliefprofil (4) eine vielzahl von parallelen Graten (6) aus einem stark dotierten Halbleitermaterial aufweist.

2. Beugungsgitter nach Anspruch 1, dadurch gekennzeichnet, dass das Halbleitermaterial Silizium ist und dass das Silizium in den stark dotierten Zonen (3) Atome eines Elementes der III. Hauptreihe mit einer Dichte von wenigstens 10¹⁸cm⁻³ aufweist.

3. Beugungsgitter nach Anspruch 2, dadurch gekennzeichnet, dass das Silizium in den Zonen (3) mit Bor dotiert ist.

4. Beugungsgitter nach einem der Ansprüche 1 bis 3, dadurch gekennzeichnet, dass das Reliefprofil (4) eine symmetrische Sägezahnform aufweist und dass die <100>-Richtung die auszeichnende 〈hkl〉-Richtung des Wafers (1) ist.

5. Beugungsgitter nach einem der Ansprüche 1 bis 3, dadurch gekennzeichnet, dass das Reliefprofil (4) eine Rechteckform aufweist und dass die 〈110〉-Richtung die auszeichnende 〈hkl〉-Richtung des Wafers (1) ist.

6. Beugungsgitter nach einem der Ansprüche 1 bis 5, dadurch gekennzeichnet, dass die Gitterfrequenz eine Aenderung nach einer vorbestimmten Funktion aufweist.

7. Verfahren zur Herstellung eines Beugungsgitter nach Anspruch 1, dadurch gekennzeichnet, dass eine Aetzmaske aus stark dotierten Zonen (3) auf der Oberfläche (2) eines Wafers (1) gebildet wird und dass mittels eines anisotrop wirkenden alkalischen Aetzmittels ein Reliefprofil (4) in die Oberfläche (2) des Wafers (1) entlang einer den Wafer (1) auszeichnenden 〈hkl〉-Richtung eingeätzt wird.

8. Verfahren nach Anspruch 7, dadurch gekennzeichnet, dass auf der Oberfläche (2) mit einer Photoresistschicht (10) abgedeckt wird, dass in der Photoresistschicht (10) wenigstens ein Profil (16) in der Gitterfläche (14) mit der vorbestimmten Gitterfrequenz erzeugt wird, dass eine Implantiermaske aus einem metallbedeckten Photoresist mit Oeffnungen (23) erzeugt wird, dass mittels Implantation von Ionen der III. Hauptgruppe durch die Implantiermaske hindurch der Halbleiter an der Oberfläche (2) stark dotiert wird und dass nach dem Entfernen der Implantiermaske aus stark dotierten Zonen (3) eine Aetzmaske für ein anisotrop wirkendes alkalisches Aetzmittel gebildet wird.

9. Verfahren nach Anspruch 8, dadurch gekennzeichnet, dass zur Erzeugung der Implantiermaske die Oberfläche (2) des Wafers (1) vor dem Auftragen des Photoresist mit einer dünnen, lichtabsorbierenden Antireflexschicht (9) abgedeckt wird, dass mittels Belichten mit einem Interferenzmuster oder mit einem anderen Streifenmuster und mittels Entwickeln auf der Photoresistschicht (10) das Profil (16) erzeugt wird, dass das Profil (16) auf einer Metalldampfquelle (17) zugewandten Flanken unter einem vorbestimmten ersten Einfallswinkel zwischen 30° und 80° mit einer ersten Metallschicht (19) bedampft wird, dass Photoresist aus der Photoresistschicht (10), der nicht mit der ersten Metallschicht (19) geschützt ist, mittels reaktiven Ionenätzens bis zu einer vorbestimmten Tiefe wegoxidiert wird und in der Photoresistschicht (10) eine neue Profilstruktur (20) mit steilen Flanken gebildet wird, dass die Profilstruktur (20) nochmals auf den der Metalldampfquelle (17) zugewandten Flanken unter einem vorbestimmten zweiten Einfallswinkel von höchstens 30° mit einer zweiten Metallschicht (21) bedampft wird und dass anschliessend auf den mit der zweiten Metallschicht (21) nicht abgedeckten Flanken und daran anschliessenden, schmalen Streifen der Profilstruktur (20) die Photoresistschicht (10) und die Antireflexschicht (9) mittels des reaktiven Ionenätzens bis auf die Oberfläche (2) des Wafers (1) wegoxidiert wird.

10. Verfahren nach Anspruch 8, dadurch gekennzeichnet, dass zur Erzeugung der Implantiermaske die Photoresistschicht (10) direkt auf den Wafer (1) aufgetragen wird, dass mittels Belichten mit kohärentem Licht (15) in der Photoresistschicht (10) stehende Wellen in einem Streifenmuster über der reflektierenden Oberfläche (2) gebildet werden, dass nach dem Entwickeln des belichteten Photoresist auf der Photoresistschicht (10) ein Profil (16) mit überhängenden Flanken erzeugt wird, dass auf einer Metalldampfquelle (17) zugewandte Flanken des in der Photoresistschicht (10) erzeugten Profils (16) unter einem vorbestimmten Einfallswinkel von höchstens 45° bedampft und mit einer einzigen Metallschicht (25) überzogen wird und dass anschliessend der auf den mit der einzigen Metallschicht (25) nicht abgedeckte Photoresist der Photoresistschicht (10) mittels reaktiven Ionenätzens bis auf die Oberfläche (2) des Wafers (1) wegoxidiert wird.

11. Verfahren nach einem der Ansprüche 7 bis 10, dadurch gekennzeichnet, dass der Wafer (1) aus Silizium hergestellt wird, dass in den Zonen (3) Ionen des Elementes Bor in der Oberfläche (2) mit einer lokalen Dosis von mehr als 10¹⁵cm⁻² implantiert werden.

12. Verfahren nach einem der Ansprüche 7 bis 11, dadurch gekennzeichnet, dass der Wafer (1) mit der Aetzmaske in zwei Schritten geätzt wird, dass wenigstens ein Teilgebiet (28) der Waferfläche (14) mit einer Deckschicht (29) abgedeckt wird, dass im ersten Schritt mittels des anisotrop wirkenden alkalischen Aetzmittels das Beugungsgitter ausserhalb des Teilgebiets (28) in der Waferfläche (14) erzeugt wird und dass im zweiten Schritt mittels eines saueren, isotrop wirkenden Aetzmittels, das auf den Wafer (1) einwirkt, selektiv die stark dotierten Zonen (3) aus der Oberfläche (2) entfernt werden.

## Claims

1. A diffraction grating etched into a wafer (1) of a single crystal of a semiconductor, with a relief profile (4) which is predetermined by a distinctive 〈hkl〉 -direction of the wafer, and a grating frequency of more than 10 per mm, characterised in that the relief profile (4) has a plurality of parallel ridges (6) of a heavily doped semiconductor material.

2. A diffraction grating according to claim 1 characterised in that the semiconductor material is silicon and that in the heavily doped zones (3) the silicon has atoms of an element of the IIIrd main series of a density of at least 10¹⁸ cm⁻³.

3. A diffraction grating according to claim 2 characterised in that the silicon in the zones (3) is doped with boron.

4. A diffraction grating according to one of claims 1 to 3 characterised in that the relief profile (4) has a symmetrical sawtooth shape and that the 〈100〉 -direction is the distinctive 〈hkl〉 -direction of the wafer (1).

5. A diffraction grating according to one of claims 1 to 3 characterised in that the relief profile (4) is of rectangular shape and that the 〈110〉 -direction is the distinctive 〈hkl〉 -direction of the wafer (1).

6. A diffraction grating according to one of claims 1 to 5 characterised in that the grating frequency has a variation in accordance with a predetermined function.

7. A process for production of a diffraction grating according to claim 1 characterised in that an etching mask of heavily doped zones (3) is formed on the surface (2) of a wafer (1) and that a relief profile (4) is etched by means of an anisotropically active alkaline etching agent into the surface (2) of the wafer (1) along a 〈hkl〉 - direction which is distinctive of the wafer (1).

8. A process according to claim 7 characterised in that the surface (2) is covered with a photoresist layer (10), that at least one profile (16) is produced in the photoresist layer (10) in the grating surface (14) with the predetermined grating frequency, that an implantation mask is produced from a metal-covered photoresist with openings (23), that the semiconductor is heavily doped at the surface (2) by means of implantation of ions of the IIIrd main group through the implantation mask and that after removal of the implantation mask from heavily doped zones (3) an etching mask is formed for an anisotropically active alkaline etching agent.

9. A process according to claim 8 characterised in that for production of the implantation mask the surface (2) of the wafer (1), prior to application of the photoresist, is covered with a thin, light-absorbent anti-reflection layer (9), that the profile (16) is produced by means of exposure with an interference pattern or with another band pattern and by means of development on the photoresist layer (10), that the profile (16) is metallised with a first metal layer (19) on flanks which are towards a metal vapour source (17), at a predetermined first angle of incidence of between 30 and 80°, that photoresist is oxidised away from the photoresist layer (10) which is not protected by the first metal layer (19) by means of reactive ion etching to a predetermined depth and a new profile structure (20) with steep flanks is formed in the photoresist layer (10), that the profile structure (20) is metallised again with a second metal layer (21) on the flanks which are towards the metal vapour surface (17), at a predetermined second angle of incidence of at most 30°, and that then the photoresist layer (10) and the anti-reflection layer (9) are oxidised away by means of reactive ion etching to the surface (2) of the wafer (1) on the flanks which are not covered by the second metal layer (21) and narrow strips adjoining same of the profile structure (20).

10. A process according to claim 8 characterised in that for production of the implantation mask the photoresist layer (10) is directly applied to the wafer (1), that standing waves are formed by means of exposure with coherent light (15) in the photoresist layer (10) in a band pattern over the reflecting surface (2), that after development of the exposed photoresist a profile (16) is produced with overhanging flanks on the photoresist layer (10), that flanks, which are towards a metal vapour source (17), of the profile (16) produced in the photoresist layer (10) receive a vapour deposition at a predetermined angle of incidence of at most 45° and are covered with a single metal layer (25), and that then the photoresist of the photoresist layer (10), which is not covered by the single metal layer (25), is oxidised away by means of reactive ion etching to the surface (2) of the wafer (1).

11. A process according to one of claims 7 to 10 characterised in that the wafer (1) is produced from silicon, and that ions of the element boron are planted in the surface (2) in the zones (3) with a local dose of more than 10¹⁵ cm⁻².

12. A process according to one of claims 7 to 11 characterised in that the wafer (1) is etched with the etching mask in two steps, that at least a portion (28) of the wafer surface (14) is covered with a cover layer (29), that in the first step the diffraction grating is produced by means of the anisotropically active alkaline etching agent outside the portion (28) in the wafer surface (14) and that in the second step the heavily doped zones (3) are selectively removed from the surface (2) by means of an acid, isotropically active etching agent which acts on the wafer (1).

## Revendications

1. Réseau de diffraction, formé par gravure dans une pastille (1) constituée d'un monocristal d'un semiconducteur, avec un profil en relief (4) prédéterminé par une direction-〈hkl〉 prépondérante de la pastille et avec une fréquence de réseau de plus de 10 lignes par mm, caractérisé en ce que le profil en relief (4) comporte un grand nombre d'arêtes (6) parallèles, constituées d'un matériau semiconducteur fortement dopé.

2. Réseau de diffraction selon la revendication 1, caractérisé en ce que le matériau semiconducteur est du silicium et en ce que le silicium comporte, dans les zones (3) fortement dopées, des atomes d'un élément du troisième groupe principal, d'une densité d'au moins 10¹⁸cm⁻³.

3. Réseau de diffraction selon la revendication 2, caractérisé en ce que le silicium situé dans les zones (3) est dopé avec du bore.

4. Réseau de diffraction selon une des revendications 1 à 3, caractérisé en ce que le profil en relief (4) a une forme en dents de scie symétrique et en ce que la direction- 〈100〉 est la direction- 〈hkl〉 prépondérante de la pastille (1).

5. Réseau de diffraction selon une des revendications 1 à 3, caractérisé en ce que le profil en relief (4) a une forme rectangulaire et en ce que la direction-〈110〉 est la direction-〈hkl〉 prépondérante de la pastille (1).

6. Réseau de diffraction selon une des revendications 1 à 5, caractérisé en ce que la fréquence de réseau varie en correspondance à une fonction prédéterminée.

7. Procédé de fabrication d'un réseau de diffraction selon la revendication 1, caractérisé en ce qu'un masque de gravure est créé à partir des zones fortement dopées (3) sur la surface (2) d'une pastille (1) et en ce que, au moyen d'un agent alcalin de gravure à action anisotrope, un profil en relief (4) est formé par gravure dans la surface (2) de la pastille (1) le long d'une direction-〈hkl〉 prépondérante de la pastille (1).

8. Procédé selon la revendication 7, caractérisé en ce que la surface (2) est recouverte avec une couche de substance photosensible (10), en ce qu'on forme dans la couche de substance photosensible (10) au moins un profil (16) dans la surface de réseau (14) avec la fréquence de réseau prédéterminé, en ce qu'un masque d' implantation constitué d'une substance photosensible revêtue de métal est produit avec des ouvertures (23), en ce que, au moyen d'une implantation d'ions d'un troisième groupe principal, passant à travers le masque d'implantation, le semiconducteur est fortement dopé dans la surface (2) et en ce que, après l'enlèvement du masque d'implantation, un masque de gravure est formé à partir des zones fortement dopées (3) pour un agent alcalin de gravure à action anisotrope.

9. Procédé selon la revendication 8, caractérisé en ce que, pour former le masque d'implantation, la surface (2) de la pastille (1) est recouverte, avant le dépôt de la substance photosensible, d'une mince couche antiréfléchissante (9) absorbant la lumière, en ce que, au moyen d'une exposition avec un motif d'interférence ou bien avec un autre motif à bandes, et au moyen d'un développement, le profil (16) est produit sur la couche de substance photosensible (10), en ce que le profil (16) est soumis à une vaporisation d'une première couche métallique (19) sur des flancs dirigés vers une source de vapeur métallique (17) en opérant avec un premier angle d'incidence prédéterminé compris entre 30° et 80°, en ce que de la substance photosensible est enlevée de la couche (10), qui n'est pas protégée par la première couche métallique (19), au moyen d'une oxydation par gravure ionique réactive jusqu'à une profondeur prédéterminée et, dans la couche de substance photosensible (10) , une nouvelle structure de profil (20) est formée avec des flancs à fortes pentes, en ce que la structure de profil (20) est encore une fois soumise à une vaporisation d'une seconde couche métallique (21), sur les flancs dirigés vers la source de vapeur métallique (17), en opérant avec un second angle d'incidence prédéterminé qui est au maximum de 30°, et en ce qu'ensuite, sur les flancs non recouverts par la seconde couche métallique (21) et sur les bandes étroites, situées à la suite, de la structure de profil (20), la couche de substance photosensible (10) et la couche antiréfléchissante (9) sont enlevées par oxydation au moyen d'une gravure ionique réactive jusqu'à la surface (2) de la pastille (1).

10. Procédé selon la revendication 8, caractérisé en ce que, pour produire le masque d'implantation, la couche de substance photosensible (10) est déposée directement sur la pastille (1), en ce que, au moyen d'une exposition avec de la lumière cohérente (15), des ondulations existant dans la couche photosensible (10) sont agencées sous forme d'un motif à bandes sur la surface réfléchissante (2), en ce que, après le développement de la substance photosensible exposée sur la couche photosensible (10), un profil (16) est produit avec des flancs en surplomb, en ce que, sur les flancs, dirigés vers la source de vapeur métallique (17), du profil (16) produit dans la couche photosensible (10), on vaporise et on dépose une seule couche métallique (25) en opérant avec un angle d'incidence prédéterminé qui est au maximum de 45° et en ce qu'ensuite la substance photosensible de la couche (10), qui n'est pas recouverte par l'unique couche métallique (25), est enlevée par oxydation au moyen d'une gravure ionique réactive jusqu'à la surface (2) de la pastille (1).

11. Procédé selon une des revendications 7 à 10, caractérisé en ce que la pastille (1) est réalisée en silicium, en ce que dans les zones (3) des ions de l'élément bore sont implantés dans la surface (2) avec une dose locale de plus de 10¹⁵cm⁻².

12. Procédé selon une des revendications 7 à 11, caractérisé en ce que la pastille (1) est gravée avec le masque de gravure en deux étapes, en ce qu'au moins une zone partielle (28) de la surface de pastille (14) est recouverte par une couche de recouvrement (29), en ce que dans une première étape, au moyen de l'agent alcalin de gravure à action anisotrope, le réseau de diffraction est formé à l'extérieur de la zone partielle (28) dans la surface de pastille (14) et en ce que, dans une seconde étape, au moyen d'un agent de gravure acide à action isotrope, qui agit sur la pastille (1), des zones fortement dopées (3) sont enlevées sélectivement de la surface (2).
